# FASCICULE DE BREVET EUROPEEN

(11) **EP 1 076 882 B1**
(45) Date de publication et mention de la délivrance du brevet: **14.05.2003**
(21) Numéro de dépôt: 99919339.4
(22) Date de dépôt: 17.05.1999
(51) Int. Cl.: G06K 19/077

(54) **CARTE A CIRCUIT INTEGRE COMPORTANT UN BORNIER D'INTERFACE ET PROCEDE DE FABRICATION D'UNE TELLE CARTE**
CHIPKARTE MIT LEITERRAHMEN UND VERFAHREN ZUR HERSTELLUNG EINER SOLCHEN KARTE
INTEGRATED CIRCUIT CARD COMPRISING AN INTERFACE TERMINAL STRIP AND METHOD FOR MAKING SAME

(30) Priorité: 15.05.1998 FR 9806470
(43) Date de publication de la demande: 21.02.2001
(73) Titulaire: Gemplus, 13881 Gémenos Cedex (FR)
(72) Inventeur: FIDALGO, Jean, Christophe, F-13420 Gémenos (FR); DOSSETTO, Lucile, F-13600 La Ciotat (FR)
(86) Numéro de dépôt international: FR9901167
(87) Numéro de publication internationale: WO99060519

(56) Documents cités:
- EP-A- 0 772 232
- FR-A- 2 735 256
- FR-A- 2 744 271
- US-A- 4 674 175
- US-A- 4 835 846
- US-A- 5 005 282

## Description

L'invention concerne une carte à puce comportant un bornier à plages de contact réalisées par dépôt d'encre.

Sur ces plages de contact, sont destinées à s'appuyer des lames de contact d'un circuit d'exploitation.

Une norme internationale définit le nombre, la taille et la position des plages de contact par rapport aux bords externes du corps de carte. Chacun de ces appareils comporte par exemple un connecteur qui est muni d'une série de lames de contact qui sont destinées à venir en appui contre les plages de contact d'une carte engagée dans le connecteur, les lames de contact assurant la liaison électrique entre le circuit intégré de la carte et le circuit d'exploitation de l'appareil.

Selon la norme, la taille des plages de contact est relativement importante pour garantir que les lames viennent en appui sur les plages sans imposer de contraintes trop strictes quant au positionnement relatif de la carte et du connecteur.

Des plages de contact sont réalisées par découpe d'une plaque métallique.

Il a déjà été proposé de réduire les coûts liés au coût de la matière des contacts, réalisées par dépôt d'une encre conductrice, par exemple par sérigraphie, offset, flexographie, tampographie.

Ainsi, on connaît des cartes dans lesquelles le circuit intégré est directement implanté dans le corps de carte, et les plages de contact et connexions sont réalisés par sérigraphie.

Un inconvénient est que l'implantation du circuit intégré dans le corps de carte doit se faire avec précaution pour ne pas le rompre. De plus l'implantation doit être effectuée avec une grande précision notamment angulaire. Un autre inconvénient est que la sérigraphie est délicates, notamment quant au positionnement relatif du circuit intégré et des plages La précision requise pour cette opération de sérigraphie empêche qu'elle ne soit réalisée à très grande cadence.

L'invention a donc pour but de diminuer le coût en matière première, tout en rendant possible des cadences de production élevées.

Le document EP0772232 Schlumberger décrit un module au format standard, où les bornes sont obtenues par dépôt de sérigraphie d'encre chargée d'argent, sur une feuille dont l'autre face comporte des motifs d'interconnexion. Les préanbules des revendications 1 et 6 sont basés sur le document.

Le document US4674175 ou FR2579798 ETA décrit un module obtenu à partir d'une grille métallique emboutie, et d'une puce noyée dans un pavé synthétique. Par chauffage à ultrasons, le pavé est chauffé pour faire pénétrer des langues d'encrage en métal.

Le document US4835846 ou FR2620586 Electronic Marin décrit la fabrication d'un module avec une feuille métallique mise en forme par gravure ou estampage. Un substrat isolant est revêtu d'adhésif et reçoit la feuille mise en forme. Des conducteurs obtenus par photolithographie relient la puce et les plages.

Le document US5005282 ou FR2632100 Schlumberger vise lui aussi un module au format standard, où les bornes sont obtenues par dépôt.

Le document FR2735256 Solaic décrit un module au format standard, où les bornes sont obtenues par dépôt.

Le document FR2744271 Solaic décrit une carte avec une puce enchâssée dans le corps. Des lignes conductrices se terminent par une zone terminale qui vient au droit d'une plage de contact sur un film de protection.

A cet effet, l'invention est définie dans les revendications.

Ainsi, on associe une technique de réalisation économique de plages de contact (par dépôt d'encre conductrice) à l'usage d'un module plus réduit dont la puce a ses plots reliés à des bornes de dimension suffisamment grande pour permettre une connexion aisée avec les plages de contact par un dépôt d'encre.

D'autres caractéristiques et avantages de l'invention apparaîtront dans la description qui suit des dessins annexés dans lesquels :
- la figure 1 illustre de manière schématique et en plan un ruban métallique dans lequel sont aménagées des fentes de démarcation des bornes du bornier ;
- la figure 2 est une vue similaire à celle de la figure 1 dans laquelle on a illustré le contour, éventuellement prédécoupé, des modules qui sont destinés à être réalisés sur le ruban de la figure 1 ;
- la figure 3 est une vue simijaire à celles des figures 1 et 2 illustrant le montage d'un circuit intégré sur la face inférieure du ruban de la figure 2, ainsi que la réalisation, par exemple par liaison filaire, de la liaison électrique entre les bornes du circuit intégré et celles du bornier ;
- la figure 4 est une vue partielle en section selon la ligne 4-4 de la figure 3 ;
- la figure 5 est une vue similaire à celle de la figure 4 illustrant un circuit intégré une fois réalisée son encapsulation par une résine de protection ;
- la figure 6 est une vue en coupe selon la ligne 6-6 de la figure 7 illustrant un corps de carte dans lequel est agencé un module incorporant notamment le circuit intégré, le bornier d'interface et la résine d'encapsulation ;
- la figure 7 est une vue de dessus du corps de carte montrant plus particulièrement les plages de contact réalisées par dépôt d'encre conductrice et dont une portion chevauche au moins partiellement une des bornes du bornier d'interface.

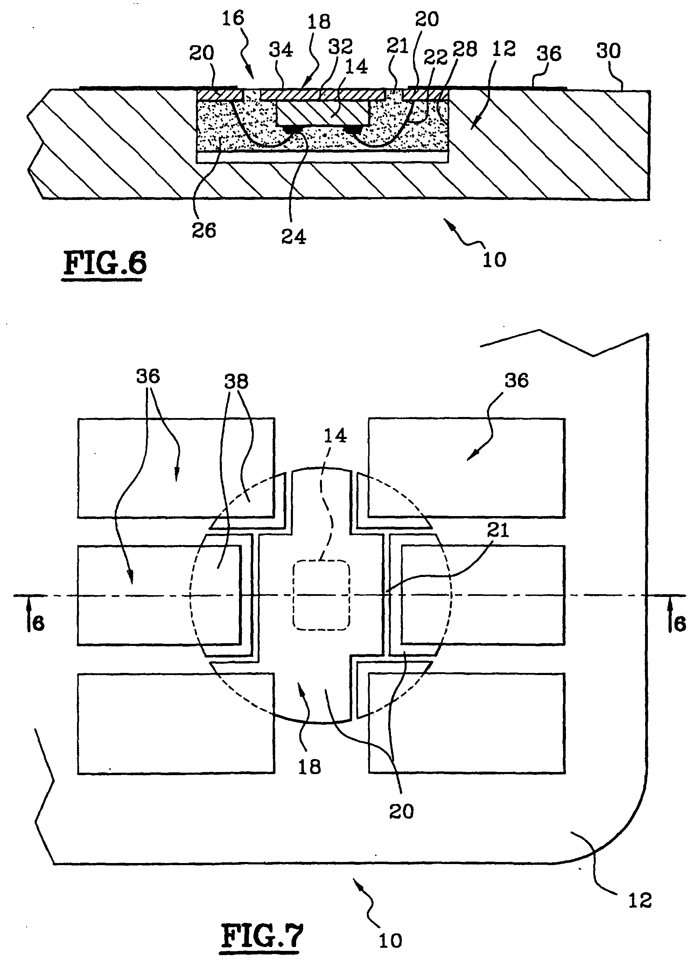

On a représenté sur les figures 6 et 7 une carte à circuit intégré 10, également appelée carte à puce ou carte à mémoire, qui comporte pour l'essentiel un corps de carte 12, généralement de forme rectangulaire à coins arrondis et réalisé en matière plastique, dans lequel est agencé au moins un circuit intégré 14 dit puce.

Conformément aux enseignements de l'invention, le circuit intégré 14 est compris dans un module 16 (module réduit en taille par rapport aux modules de type classique, par exemple deux fois plus petit ou plus) dans lequel le circuit intégré 14 est fixé du côté inférieur d'un bornier 18, comportant une série de bornes 20 dont chacune est reliée, par exemple par l'intermédiaire d'un fil de connexion 22, à un plot 24 du circuit intégré 14. La face inférieure du module 16 est par ailleurs recouverte d'une couche de résine d'encapsulation 26 dans laquelle sont noyés le circuit intégré 14 ainsi que les fils de manière à assurer leur protection.

Le module 16 ainsi constitué et qui, dans l'exemple de réalisation, est de forme circulaire en vue de dessus, est agencé à l'intérieur d'une cavité 28 aménagée dans le corps de carte 12 et qui débouche dans une face supérieure 30 de celui-ci.

Comme on peut le voir sur les figures, le circuit intégré 14 est fixé par une face supérieure 32 contre une face inférieure d'une borne centrale 20 du bornier 18. Dans le cas où le circuit intégré nécessite une connexion à la masse électrique, on prévoira avantageusement de fixer le circuit 14 sur la borne centrale 20 à l'aide d'une colle conductrice. Dans le cas contraire, on utilisera plutôt une colle isolante.

Les fils de connexion 22 qui relient électriquement chacune des bornes 20 du bornier 18 aux plots correspondants 24 du circuit intégré 14 sont soudés par tout procédé habituel, tel que le soudage à ultrasons ou le soudage thermosonique. Le bornier 18 est réalisé par découpe d'un élément de plaque métallique, notamment un élément de plaque en cuivre éventuellement recouvert, par dépôt électrolytique, de divers métaux tels que le nickel, l'argent ou l'or.

Bien entendu, plutôt qu'une liaison de type filaire, on pourra choisir de relier électriquement le circuit électrique aux bornes 20 du bornier 18 par tout procédé connu de liaison électrique utilisé jusqu'à présent dans le cadre de la liaison électrique d'un circuit intégré aux plages de contact de la carte lorsque ces dernières sont réalisées de manière connue par découpe d'un élément de plaque de matériau conducteur. Un exemple de ces techniques alternatives est par exemple celle connue de l'homme du métier sous le nom de "flip-chip".

Comme on peut le voir sur la figure 6, le module 16 est engagé dans la cavité 28 de telle sorte que la face supérieure 34 des bornes 20 du bornier 18 affleure au même niveau que la face supérieure 30 du corps de carte 12. De plus, on prévoira que le module 16 soit reçu avec un jeu minimum dans la cavité 28, voire même avec un léger serrage, de telle sorte qu'il n'y ait pas de discontinuité entre la face supérieure du module 16 et celle du corps de carte 12.

Comme on peut le voir notamment sur la figure 7, chaque borne 20 du bornier 18 est indépendante électriquement des autres, les bornes 20 étant séparées des autres par des fentes de démarcation 21.

De la sorte, il est possible de réaliser, sur la face supérieure 30 du corps de carte 12, des plages de contact 36 dont la forme et la taille sont conformes à une norme particulière régissant un type particulier de carte à circuit intégré.

Ces plages de contact 36 sont réalisées par dépôt d'une encre conductrice, par exemple par sérigraphie, par offset, par flexographie ou par tampographie.

Ces techniques, que l'on nommera sous le vocable générique de techniques d'impression, permettent de réaliser, à très fortes cadences, des plages de contact 36 qui ne nécessitent que très peu de matière première étant donnée leur très faible épaisseur qui, sur la figure 6, a été délibérément exagérée pour plus de clarté de la représentation.

Conformément aux enseignements de l'invention, chacune des plages de contact 36 qui est destinée à permettre la connexion électrique entre le circuit intégré et un circuit d'exploitation comporte au moins une portion 38 qui recouvre au moins une partie d'une des bornes 20 du bornier 18.

Ainsi, l'encre conductrice étant déposée à même la surface supérieure de la borne 20 correspondante, les plages de contact 36 sont liées électriquement aux bornes 20 du bornier 18 et, par l'intermédiaire des fils de connexion 22, aux plots 24 du circuit intégré 14.

Ainsi, grâce à l'invention, on peut réaliser des cartes à circuit intégré dont le module 16 qui incorpore le circuit intégré 14 et le bornier 18 est de taille particulièrement réduite par rapport aux modules connus jusqu'à présent dont la taille minimale était celle imposée par la forme des plages de contact normalisées 36.

De même, l'invention permet de réduire de manière importante la quantité de matière utilisée que ce soit en ce qui concerne la plaque métallique dans laquelle est découpé le bornier 18, ou que ce soit en ce qui concerne la résine d'encapsulation 26.

On décrira maintenant un procédé de fabrication d'une carte à circuit intégré conforme aux enseignements de l'invention.

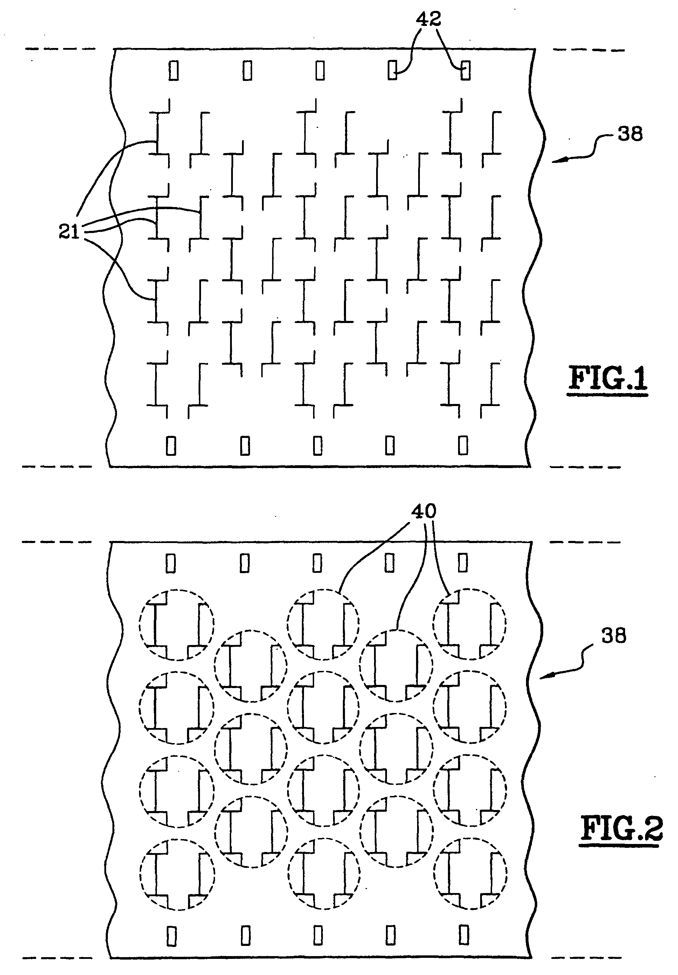

Dans une première étape de ce procédé, illustrée à la figure 1, on découpe dans un ruban métallique 38 des fentes de démarcation 21 qui sont destinées à démarquer des bornes 20 d'une série de borniers 18 qui sont répartis sur le ruban 38.

Éventuellement, ainsi que cela est illustré à la figure 2, on peut alors procéder à une étape de prédécoupe du contour externe 40 des structures de modules 18 dont on voit plus particulièrement sur cette figure qu'ils sont par exemple disposés en quinconce en vue d'utiliser au mieux la surface disponible du ruban 38, et donc de limiter les chutes de matière. Il est cependant tout à fait possible de disposer 4 modules alignés dans le sens de la largeur du ruban pour faciliter la gestion de la découpe et du transfert des modules en ayant un nombre de module constant et pair dans le sens de la largeur.

Le ruban 38 est par exemple un ruban de cuivre recouvert d'une ou plusieurs couches de métal, déposées par exemple par dépôt électrolytique, et destinées à améliorer la qualité du contact électrique. Le ruban 38 comporte deux séries latérales de trous 42 qui sont perçés le long de ses bords longitudinaux et qui permettent d'assurer très facilement son entraînement dans des machines de transfert par des galets à picots.

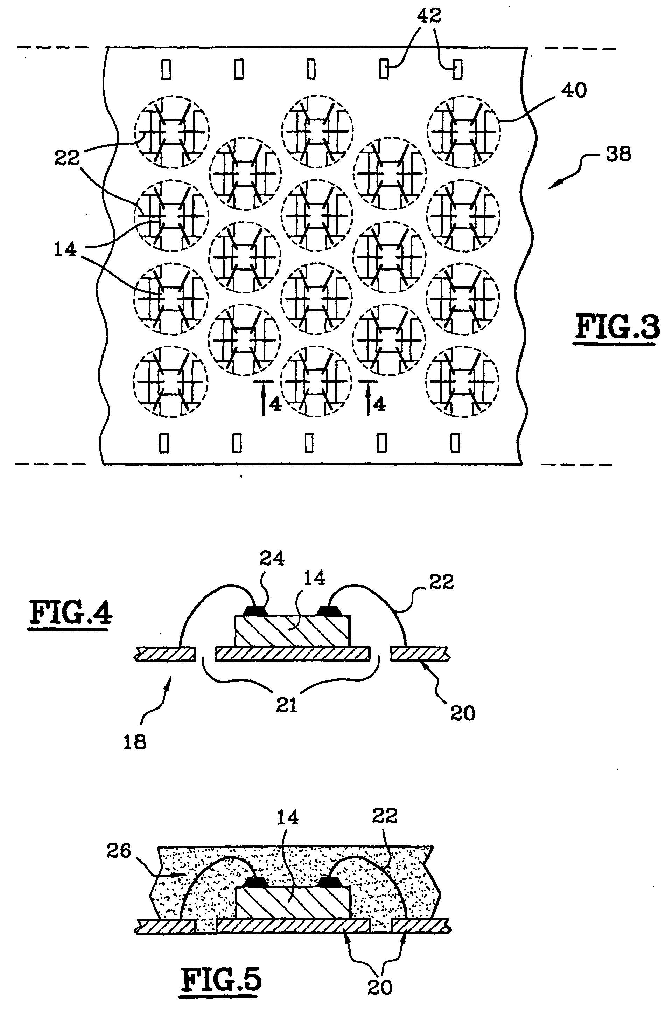

Dans l'exemple illustré à la figure 3, on a fixé sur la face inférieure du ruban 38, sensiblement au centre de chaque futur module 18, un circuit intégré 14 et on a réalisé la liaison électrique entre les bornes de sortie 14 et les bornes 20 du bornier 18.

A la figure 5, on a illustré de manière partielle le ruban 38 après qu'a été déposée, sur la face inférieure du bornier 18, une résine d'encapsulation qui est destinée à la fois à protéger le circuit intégré 14 et les fils de connexion 22 dans le cas où la liaison électrique entre le circuit 14 et le bornier 18 est réalisée de cette manière, mais aussi pour assurer le maintien et la fixation des différentes bornes 20 du bornier 18 lorsque celui-ci sera découpé selon son contour 40 ne laissant alors subsister aucune continuité de matière entre chacune des bornes 20.

Le dépôt de la résine d'encapsulation peut se faire par divers procédés connus.

Selon une première technique, on dépose sur tout le ruban 38 une couche de résine, sous une forme fluide, dont on maîtrise l'épaisseur par exemple par raclage ou tamponnage. On assure alors la réticulation de la résine, par exemple, en fonction de la nature de la résine, par rayonnement ultraviolet ou par chauffage.

Bien entendu, il est important au cours de cette opération que la face supérieure 34 des bornes 20 reste exempte de toute trace de résine pour pouvoir assurer la liaison électrique avec les plages de contact 36. A cet effet, on peut prévoir de plaquer la face supérieure du bornier 18 contre une courroie de transport, par exemple par aspiration, ou on peut prévoir de recouvrir cette face supérieure du ruban par un adhésif qui sera ultérieurement détaché.

Dans une variante de ce procédé, on peut, au lieu d'appliquer une couche de résine sur toute la largeur du ruban, déposer de la résine sous la forme d'une ou deux gouttes qui recouvrent uniquement les parties du ruban 38 qui sont effectivement destinées à former les modules 16. Cette variante, connue sous le nom de procédé "glob top", peut éventuellement nécessiter de procéder à une étape de fraisage postérieure à la réticulation de la résine, afin d'assurer une parfaite maîtrise de l'épaisseur de la couche de résine. Toutefois, cette variante permet bien entendu de diminuer de manière importante la quantité de résine consommée.

Selon un autre procédé de dépôt de la résine d'encapsulation, cette opération peut également se faire sous la forme d'un moulage en apportant au contact de la face inférieure du ruban 38 des parois de moule dans lesquelles la résine est injectée et cuite pour obtenir son durcissement.

A ce stade de la fabrication, on a donc un ruban 38 de modules 16, ruban qu'il est possible d'enrouler en bobine.

A ce moment-là, il est possible de séparer individuellement chaque micromodule, en utilisant un procédé de découpe faisant appel par exemple à un poinçon et une matrice, soit à un faisceau laser.

Le module ainsi formé est alors engagé, au cours d'une opération dite d'encartage, dans la cavité 28 du corps de carte 12. La cavité 28 peut être réalisée soit au cours du moulage, le corps de carte est réalisé par moulage par injection, ou par usinage.

La fixation du module 16 dans la cavité 28 peut se faire soit par collage, soit tout simplement par serrage. En effet, il est prévu que le module 16 soit reçu avec un serrage suffisant dans la cavité 28.

Au cours de l'opération d'encartage, il est nécessaire de bien maîtriser le positionnement en profondeur du module 16 dans la cavité 28 afin d'obtenir un parfait affleurement entre la face supérieure 34 des bornes 20 et la face supérieure 30 du corps de carte 12.

En variante, on peut également prévoir que le corps de carte 12 soit surmoulé autour du module 16 qui, dans ce cas, est agencé dans le moule de la carte précédemment à l'injection de la matière. Cette variante permet de garantir le bon positionnement relatif des faces supérieures 30, 34 du corps de carte 12 et du module 16.

Dans une autre variante du procédé de réalisation de la carte selon l'invention, le module 16 est découpé du ruban 38 juste après les étapes illustrées aux figures 3 et 4, c'est-à-dire avant que la face inférieure du bornier 18 ne soit recouverte d'une résine d'encapsulation. Dans ce cas, pour maintenir une position relative adéquate des bornes 20 du bornier 18, il est nécessaire de disposer, par exemple sur la face supérieure du bornier 18, avant sa découpe le long du contour 40, un ruban adhésif. Le module ainsi réalisé, dépourvu de résine d'encapsulation, est destiné à être reçu dans une cavité du corps de carte qui est étagée. Dans une partie périphérique, la profondeur de cette cavité correspond exactement à celle du bornier 18, c'est-à-dire correspondant à l'épaisseur du ruban 38. Dans une partie centrale, la cavité présente une plus grande profondeur et elle est remplie d'une résine non encore réticulée de telle sorte, lorsque le module est encarté dans le corps de carte 12, le circuit intégré 14 et les fils de connexion 12 viennent se noyer dans la résine précédemment déposée dans la cavité.

Dans tous les cas, une fois que le corps de carte 12 est pourvu du module 16 dont les bornes 20 affleurent à la surface supérieure 30 du corps de carte 12, il est possible de réaliser les plages de contact 36 selon tout procédé approprié d'impression d'une encre conductrice. La technique d'impression sera choisie de manière à permettre des cadences de production extrêmement élevées.

L'encre est déposée de telle sorte que les plages de contact 36 s'étendent en partie sur l'une des bornes 20 du bornier 18 et en partie sur la face supérieure du corps de carte 12. Bien entendu, la forme des plages conductrices 36 doit recouvrir au moins les superficies définies par la norme, mais elles peuvent éventuellement dépasser ces normes minimales.

L'encre conductrice peut être soit une résine polymère chargée de particules conductrices, telle qu'une résine epoxy chargée de particules d'argent, de cuivre ou d'or, soit un polymère intrinsèquement conducteur.

Dans les deux cas, le polymère peut être soit un thermodurcissable, soit un thermoplastique, soit un mélange des deux.

L'encre peut être une encre à solvant, une encre thermodurcissable mono ou bi composant ou une encre polymérisable sous un rayonnement ultraviolet

Le dépôt d'encre conductrice peut être réalisé par sérigraphie, ou par jet d'encre ou par tampographie en utilisant un tampon encreur à déplacement vertical ou rotatif, ou par une technique offset utilisant un rouleau de type blanchet pour le transfert de l'encre sur la carte et le module.

L'encre conductrice utilisée peut être constituée d'une pâte à braser ou d'un alliage métallique.

L'encre conductrice peut comprendre de préférence un matériau souple apte à absorber des déformations sans que le contact électrique ne soit rompu au cours de flexions de la carte.

Dans un autre mode de l'invention non représenté, on pourra inverser les étapes de fabrication ainsi qu'utiliser une impression légèrement différente:

Selon ce mode, le corps de carte est imprimé de telle manière que les pistes d'encres conductrices descendent au moins en partie sur les flancs de la cavité. Si l'encre conductrice est un polymère chargé de particules conductrices, on prendra soin à ce stade de ne pas sécher ou réticuler l'encre. Le module est ensuite inséré dans la cavité de telle manière que les flancs de chacun des contacts viennent pénétrer la couche d'encre, ceci de manière à assurer une liaison électrique entre chacun des contacts du module et les pistes imprimées en encre conductrice.

La carte subi ensuite un traitement thermique de manière à soit sécher (encre à solvant), réticuler (polymère thermoplastique) ou réactiver (dans le cas d'un polymère thermoplastique ou d'une pâte à braser) l'encre conductrice. La liaison électrique est ainsi pleinement assurée.

Bien entendu, l'invention pourra aussi être mise en oeuvre pour réaliser une carte de type "combi-card" dans laquelle le circuit intégré peut aussi communiquer à distance avec le circuit d'exploitation par l'intermédiaire d'une liaison de type radiofréquence, la carte comportant alors, en plus des plages de contact, une antenne qui est liée électriquement au circuit intégré et qui est généralement réalisée par dépôt d'une encre conductrice.

Selon une variante, la face supérieure (34) du bornier peut ne pas affleurer au niveau d'une face supérieure (30) du corps de carte (12) comme dans l'exemple décrit, mais être volontairemment en retrait par rapport à celle-ci. Le cas échéant, on dispose une résine d'encapsulation venant combler le retrait.

## Revendications

1. Carte (10) à circuit intégré, du type comportant : un corps de carte (12) avec une cavité (28) ; au moins un circuit intégré (14) agencé dans un module à l'intérieur de la cavité (28) et relié électriquement à des plages de contact (36) normalisées ; ces plages normalisées (36) étant formées par une encre conductrice ; le module étant agencé à l'intérieur de la cavité (28) et débouchant à une face supérieure (30) du corps (12) ; **caractérisé en ce que** dans cette carte (10):
- le module est de taille réduite par rapport aux plages de contact (36) normalisées ;
- un bornier d'interface (18), de taille réduite par rapport aux plages de contact (36) normalisées, est agencé sur le module et muni d'une série de bornes (20) reliées électriquement à des plots (24) du circuit intégré (14) ; ce bornier (18) étant formé d'un élément de plaque de matériau métallique ;
- les plages de contact (36) en encre conductrice comportent une portion qui recouvre au moins une partie d'une des bornes (20) du bornier (18), et une portion sur la face supérieure (30) du corps de carte (12).

2. Carte selon la revendication 1, **caractérisée en ce que** le bornier (18) est reçu affleurant dans la cavité (28) sans discontinuité avec la face supérieure (30) du corps de carte (12).

3. Carte selon la revendication 1, **caractérisée en ce que** le bornier (18) est reçu dans la cavité (28) au niveau de la face supérieure (30) du corps de carte (12) en retrait par rapport à cette face (30), une résine d'encapsulation venant par exemple combler le retrait.

4. Carte selon l'une des revendications 1 à 3, **caractérisé en ce que** le bornier d'interface (18) est d'une taille réduite deux fois plus petite ou plus, par rapport aux plages de contact (36) normalisées.

5. Carte selon l'une des revendications 1 à 4, **caractérisé en ce que** l'encre conductrice comprend un matériau souple apte à absorber des déformations sans que le contact électrique ne soit rompu.

6. Procédé de fabrication d'une carte à circuit intégré, du type comportant les étapes prévoyant de : disposer d'un corps de carte (12) avec une cavité (28) ; agencer au moins un circuit intégré (14) dans un module ; ce module étant agencé à l'intérieur de la cavité (28) pour déboucher à une face supérieure du corps (12) ; former par dépôt d'une encre conductrice des plages de contact (36) normalisées et relier électriquement ces plages (36) au circuit (14) ; **caractérisé en ce qu'**il comprend les étapes de :
- découper dans un élément de plaque de matériau métallique, un bornier d'interface (18) de taille réduite par rapport aux plages de contact (36) normalisées ; ces bornier (18) étant muni d'une série de bornes (20) ;
- relier électriquement chacune des bornes (20) bornier d'interface (18) aux plots correspondants (24) du circuit intégré (14) en formant ainsi un module de taille réduite par rapport aux plages de contact (36) normalisées ; et
- après avoir agencé le module dans la cavité (28), réaliser les plages de contact (36) en encre conductrice avec : une portion qui recouvre au moins une borne (20) du bornier d'interface (18), et une portion qui recouvre au moins une partie des bornes (20) du bornier (18) et sur la face supérieure (30) du corps de carte (12), une dont la forme et la taille sont conformes à la norme.

7. Procédé selon la revendication 6, **caractérisé en ce que** l'étape de réalisation du module (16) comporte l'étape de découpe, dans un élément de plaque (38), de fentes de démarcation (21) des bornes (20) du bornier (18), ces bornes (20) restant chacune reliées à un contour externe de l'élément de plaque (38).

8. Procédé selon l'une des revendications 6 ou 7, **caractérisé en ce que** le dépôt d'encre conductrice est réalisé par jet d'encre.

9. Procédé selon l'une des revendications 6 ou 7, **caractérisé en ce que** le dépôt d'encre est réalisé par tampographie en utilisant un tampon encreur à déplacement vertical ou rotatif; ou par une technique offset utilisant un rouleau de type blanchet pour le transfert de l'encre sur la carte et le module.

10. Procédé selon l'une des revendications 6 à 8, **caractérisé en ce qu'**il comportant les étapes prévoyant de :
- imprimer des pistes d'encres conductrices sur un corps (12) de carte muni d'une cavité (28) de manière que les pistes d'encre descendent au moins en partie sur les flancs de la cavité ;
- insérer le module réduit (16) dans la cavité de manière que les flancs de chacun des contacts viennent pénétrer la couche d'encre des pistes, de manière à assurer une liaison électrique avec des bornes (20) du module ;
- durcir l'encre des pistes par séchage ou réticulation.

## Patentansprüche

1. IC-Karte (10) des Typs mit: einem Kartenkörper (12) mit einem Hohlraum (28); mindestens einer integrierten Schaltung (14), die in einem Modul innerhalb des Hohlraums (28) vorgesehen und elektrisch mit genormten Kontaktbereichen (36) verbunden ist; wobei diese genormten Bereiche (36) durch eine leitende Druckfarbe gebildet werden; wobei das Modul innerhalb des Hohlraums (28) vorgesehen ist und an einer Oberseite (30) des Körpers (12) mündet; **dadurch gekennzeichnet, dass** in dieser Karte (10) :
- das Modul in Bezug auf die genormten Kontaktbereiche (36) kleiner ist;
- eine in Bezug auf die genormten Kontaktbereiche (36) kleinere Schnittstellen-Klemmleiste (18) auf dem Modul vorgesehen und mit einer Reihe von Klemmen (20) bestückt ist, die mit Stiften (24) der integrierten Schaltung (14) elektrisch verbunden sind; wobei diese Klemmleiste (18) aus einem Plattenelement aus Metall gebildet wird;
- die Kontaktbereiche (36) aus leitender Druckfarbe einen Abschnitt aufweisen, der zumindest einen Teil einer der Klemmen (20) der Klemmleiste (18) bedeckt, und einen Abschnitt auf der Oberseite (30) des Kartenkörpers (12).

2. Karte nach Anspruch 1, **dadurch gekennzeichnet, dass** die Klemmleiste (18) bündig im Hohlraum (28) aufgenommen wird, ohne Diskontinuität mit der Oberseite (30) des Kartenkörpers (12).

3. Karte nach Anspruch 1, **dadurch gekennzeichnet, dass** die Klemmleiste (18) im Hohlraum (28) an der Oberseite (30) des Kartenkörpers (12) in Bezug auf diese Seite (30) versetzt aufgenommen wird, wobei dieser Versatz beispielsweise mit einem Einbettungsharz gefüllt werden kann.

4. Karte nach einem der Ansprüche 1 bis 3, **dadurch gekennzeichnet, dass** die Schnittstellen-Klemmleiste (18) zwei oder mehr Mal kleiner ist als die genormten Kontaktbereiche (36).

5. Karte nach einem der Ansprüche 1 bis 4, **dadurch gekennzeichnet, dass** die leitende Druckfarbe ein flexibles Material umfasst, dass Verformungen absorbieren kann, ohne den elektrischen Kontakt zu unterbrechen.

6. Herstellungsverfahren einer IC-Karte mit folgenden Etappen: Bereitstellung eines Kartenkörpers (12) mit einem Hohlraum (28); Anordnung mindestens einer integrierten Schaltung (14) in einem Modul; wobei dieses Modul innerhalb des Hohlraums (28) vorgesehen ist, um an einer Oberseite des Körpers (12) zu münden; Bildung durch Auftragen einer leitenden Druckfarbe von genormten Kontaktbereichen (36) und elektrischer Anschluss dieser Bereiche (36) an die Schaltung (14); **dadurch gekennzeichnet, dass** es die folgenden Etappen umfasst:
- Ausschneiden aus einem Plattenelement aus Metall einer in Bezug auf die genormten Kontaktbereiche (36) kleineren Schnittstellen-Klemmleiste (18) ; wobei diese Klemmleiste (18) mit einer Reihe von Klemmen (20) bestückt ist;
- Elektrischer Anschluss jeder der Klemmen (20) der Klemmleiste (18) an die entsprechenden Stifte (24) der integrierten Schaltung (14), wodurch ein in Bezug auf die genormten Kontaktbereiche (36) kleineres Modul entsteht; und
- Nach Einsetzen des Moduls in den Hohlraum, Herstellung der Kontaktbereiche (36) aus leitender Druckfarbe mit: einem Abschnitt, der mindestens eine Klemme (20) der Schnittstellen-Klemmleiste (18) bedeckt, und einem Abschnitt, der mindestens einen Teil der Klemmen (20) der Klemmleiste (18) bedeckt und, auf der Oberseite (30) des Kartenkörpers (12), einem Abschnitt dessen Form und Größe der Norm entsprechen.

7. Verfahren nach Anspruch 6, **dadurch gekennzeichnet, dass** die Herstellungsetappe des Moduls (16) eine Etappe umfasst, bei der aus einem Plattenelement (38) Abgrenzungsschlitze (21) der Klemmen (20) der Klemmleiste (18) ausgeschnitten werden, wobei diese Klemmen (20) jeweils mit einer äußeren Kontur des Plattenelements (38) verbunden bleiben.

8. Verfahren nach einem der Ansprüche 6 oder 7, **dadurch gekennzeichnet, dass** das Auftragen der leitenden Druckfarbe per Tintenstrahl erfolgt.

9. Verfahren nach einem der Ansprüche 6 oder 7, **dadurch gekennzeichnet, dass** das Auftragen der Druckfarbe per Stempeldruck mit einer vertikal versetzbaren oder rotierenden Farbrolle erfolgt; oder nach einer Offset-Technik mit einer Rolle des Typs Drucktuch für die Übertragung der Druckfarbe auf die Karte und das Modul.

10. Verfahren nach einem der Ansprüche 6 bis 8, **dadurch gekennzeichnet, dass** es die folgenden Etappen umfasst :
- Drucken von leitenden Druckfarbenbahnen auf einem mit einem Hohlraum (28) versehenen Kartenkörper (12), so dass die Druckfarbenbahnen zumindest teilweise an den Flanken des Hohlraums nach unten führen;
- Einsetzen des kleinen Moduls (16) in den Hohlraum, so dass die Flanken jeder der Kontakte in die Farbschicht der Bahnen eindringen, um eine elektrische Verbindung mit den Klemmen (20) des Moduls zu gewährleisten;
- Härten der Druckfarbe der Bahnen durch Trocknen oder Vernetzen

## Claims

1. An integrated circuit card (10), of the type comprising: a card body (12) with a cavity (28); at least one integrated circuit (14) arranged in a module inside the cavity (28) and electrically connected to standardised contact areas (36); these standardised areas (36) being formed by a conductive ink; the module being arranged inside the cavity (28) and opening into an upper face (30) of the body (12); **characterised in that**, in this card (10):
- the module is of a reduced size compared with the standardised contact areas (36) ;
- an interface terminal block (18), of a reduced size compared with the standardised contact areas (36), is arranged on the module and provided with a series or terminals (20) electrically connected to bonding pads (24) of the integrated circuit (14); this terminal block (18) being formed from a metallic material plate element;
- the contact areas (36) made of conductive ink have a portion which covers at least part of one of the terminals (20) of the terminal block (18), and a portion on the upper face (30) of the card body (12).

2. A card according to Claim 1, **characterised in that** the terminal block (18) is accommodated flush in the cavity (28) with no discontinuity with the upper face (30) of the card body (12).

3. A card according to Claim 1, **characterised in that** the terminal block (18) is accommodated in the cavity (28) in the upper face (30) of the card body (12) recessed with respect to this face (30), an encapsulation resin coming for example to fill in the recess.

4. A card according to one of Claims 1 to 3, **characterised in that** the interface terminal block (18) is reduced to half the size or smaller, compared with the standardised contact areas (36).

5. A card according to one of Claims 1 to 4, **characterised in that** the conductive ink comprises a flexible material able to absorb deformations without the electrical contact being broken.

6. A method of manufacturing an integrated circuit card, of the type comprising the steps making provision for: having available a card body (12) with a cavity (28); arranging at least one integrated circuit (14) in a module; this module being arranged inside the cavity (28) in order to open into an upper face of the body (12); forming standardised contact areas (36) by deposition of a conductive ink, and electrically connecting these areas (36) to the circuit (14) ; **characterised in that** it comprises the steps of:
- cutting, in a metallic material plate element, an interface terminal block (18) of a reduced size compared with the standardised contact areas (36) ; these terminal blocks (18) being provided with a series of terminals (20) ;
- electrically connecting each of the terminals (20) of the interface terminal block (18) to the corresponding bonding pads (24) of the integrated circuit (14), thus forming a module of a reduced size compared with the standardised contact areas (36); and
- after arranging the module in the cavity (28), producing the contact areas (36) in conductive ink with: a portion which covers at least one terminal (20) of the interface terminal block (18), and a portion which covers at least part of the terminals (20) of the terminal block (18) and on the upper face (30) of the card body (12), one with a shape and size conforming to the standard.

7. A method according to Claim 6, **characterised in that** the step of producing the module (16) comprises the step of cutting, in a plate element (38), slits (21) demarcating the terminals (20) of the terminal block (18), these terminals (20) each remaining connected to an external outline of the plate element (38).

8. A method according to either of Claims 6 or 7, **characterised in that** the conductive ink deposition is implemented by ink jet.

9. A method according to either of Claims 6 or 7, **characterised in that** the ink deposition is implemented by pad printing using an inking pad with vertical or rotary movement; or by an offset printing technique using a blanket type roller for transferring the ink onto the card and the module.

10. A method according to one of Claims 6 to 8, **characterised in that** it comprises the steps making provision for:
- printing conductive ink tracks on a card body (12) provided with a cavity (28) so that the ink tracks come down at least partly onto the sides of the cavity;
- inserting the reduced-size module (16) into the cavity so that the sides of each of the contacts penetrates the layer of ink of the tracks, so as to provide an electrical connection with the terminals (20) of the module;
- hardening the ink of the tracks by drying or cross-linking.
